# EUROPEAN PATENT APPLICATION

(11) **EP 1 693 481 A1**
(43) Date of publication of application: **23.08.2006**
(21) Application number: 05425831.4
(22) Date of filing: 23.11.2005
(51) Int. Cl.: C23C 14/04, C23C 14/56

(54) **Vacuum metallization device with means to create metal-free areas**

(71) Applicant: Galileo Vacuum Systems S.R.L., 59100 Prato (IT)
(72) Inventor: Pagani, Angelo, 40138 Bologna (IT)
(74) Representative: Mannucci, Michele

(57) **Abstract**

The system for vacuum deposition of a coating on a web material (N), comprises: a feed path of the web material in a vacuum environment; along the feed path, a process roller (19) around which said web material is guided; associated with the process roller, at least one vaporization source (31) of a material to form the coating; upstream of this source, along the feed path of the web material, an applicator unit (51) to apply a masking agent to the web material according to a pre-established pattern. The applicator unit in turn comprises a printing cylinder (53), cooperating with a distributor cylinder (55) of said masking agent, and a source (57) of masking agent. The applicator unit (51) comprises at the ends thereof, adjustment means (73) separate from each other to adjust the position of the applicator unit (51) with respect to the process roller (19).

## Description

### Technical field

The present invention relates to a system or device for metallization of a continuous substrate, such as paper, a polymer film or another material.

More specifically, the present invention relates to a device of the aforesaid type which has means to create metal-free areas of various shapes, for example to obtain a particular pattern or also technical-functional characteristics of the finished product, such as strips of non-conductive material, to produce capacitors.

### Prior art

To perform vacuum deposition of layers of metal materials on substrates, such as polymer films, paper or the like, vacuum metallization systems are commonly employed, in which a reel of substrate to be coated is inserted in a chamber and in which the substrate is subsequently unwound and fed around a process roller to be rewound in a reel of treated product. Positioned under the process roller are vaporization sources, which generate vapors of metal (or another material) which then condenses in the form of a thin coating layer on the corresponding face of the film or other substrate.

The vaporization sources are, for example, composed of boats made of highly conductive sintered material resistant to temperature, which are heated by Joule effect through the passage of an electric current. The metal to be vaporized is fed to these boats. In continuous feed systems this metal is fed in the form of wires of aluminum or another suitable material, unwound from respective reels with a feed speed corresponding to the hourly quantity of metal to be vaporized.

Systems of this type are described in WO-A-03/038142; EP-A-0082001; US-A-4,962,725; US-A-5,350,598. Particular embodiments of boats or vaporization sources heated by Joule effect suitable for use in these systems are described in EP-A-1408135.

For some specific applications, for example to produce a metallized film for the production of capacitors, or a metallized film for packaging, it is necessary to create metal-free areas according to a pattern. For this purpose, US-A-5,223,038, by way of example, describes a system of nozzles that spray an oil onto the substrate to be metallized to prevent the metal from adhering in areas that must remain metal-free. Consequently, when the film is fed around the process roller in front of the vaporization source, the areas wet with oil remain metal-free. The quantity of oil applied is extremely small and normally evaporates from the film without the need to provide specific removal means.

A system for the same purpose, in which the oil is applied to a longitudinal covering strip, to produce longitudinal metal-free bands, is described in US-A-4,478,878. US-A-5,652,022 describes a vacuum metallization device in which metal-free strips are obtained by masking formed with a continuous flexible member which covers the portion of film to remain metal-free. Both these systems are only suitable to produce metal-free bands or strips extending longitudinally.

US-A-4,832,983 and US-A-5136462 describe a system in which oil is transferred to the film to be coated in metal by a pair of rotating rollers, one to distribute the oil on the film and the other to collect the oil from a source. The latter can be composed in turn of a take-up roller and of a storage tank, or by a series of nozzles or orifices through which the oil flows to be distributed on the surface of the roller.

US-A-6,048,402 describes a device for distributing oil on a film to be metallized, composed of a transverse conduit provided with a plurality of nozzles, from which oil evaporates to condense on the film which is fed in front of the nozzles. A similar system is described in US-A-5,942,283.

EP-A-0.447.550 describes a roller system to apply oil to a film to be metallized. The applicator roller can have a raised pattern of varied configuration according to the conformation of the metal-free areas to be obtained.

### Objects and summary of the invention

The object of the present invention is to produce a metallization device or system with which areas according to a pattern or in any case metal-free areas can be produced on a continuous substrate, with simple, reliable means which are nonetheless suitable to provide high quality in defining the metal-free areas.

In substance, the invention provides for a system for vacuum deposition of a coating on a web material, comprising: a feed path of the web material in a vacuum environment; along said feed path, a process roller around which said web material is guided; associated with said process roller, at least one vaporization source of at least a first material to form said coating; upstream of said at least one source, along the feed path of the web material, an applicator unit to apply a masking agent to the web material according to a pre-established pattern, said applicator unit comprising a printing cylinder, cooperating with a distributor cylinder of said masking agent, and a source of said masking agent. Characteristically, the applicator unit comprises at the ends thereof, i.e. at the side, adjustment means separate from each other to adjust the position of the applicator unit with respect to the process roller and/or the contact force between the applicator unit and the process roller.

Preferably, the vaporization source is a vaporization source of a metal, such as, although not exclusively, aluminum. However, the present invention could also be applied to vacuum coating systems, which form depositions of non-metallic materials, such as oxides.

In a practical embodiment of the invention, the adjustment means comprise, for each side of the applicator unit, an actuator which stresses the printing cylinder towards the process roller.

For example, a respective adjustable stop, defining the position of the printing cylinder with respect to the process roller, can be associated with each end of the applicator unit.

According to an advantageous embodiment, the printing cylinder is supported in a removable way for rapid replacement. For example, on two side panels movable for movement towards the process roller, openable supports can be provided to allow removal and replacement of the printing cylinder, for example by engagement of the ends of said cylinder with gripping members operated by suitable equipment, such as a traveling crane or a hoist.

The source of masking agent can advantageously comprise a reservoir containing the masking agent in liquid form, in which the distributor cylinder is partly immersed.

The source of masking agent can comprise a reservoir and means for evaporation of said masking agent from said reservoir, the distributor cylinder being arranged in this case to obtain on the cylindrical surface thereof condensation of the masking agent evaporated from said source.

Alternatively, the distributor cylinder can be arranged partly below the level of the masking agent to have a function of suction and transfer of the product to the printing cylinder.

Further advantageous characteristics and embodiments of the invention are indicated in hereunder and in the appended claims.

### Brief description of the drawings

The invention will now be better understood by following the description and accompanying drawing, which shows a non-limiting practical exemplification of said finding. In the drawing:
Figure 1 shows a schematic cross section of the metallization system or device in which the invention is incorporated;
Figure 2 shows an enlarged detail of the system to apply oil to the substrate to be metallized; and

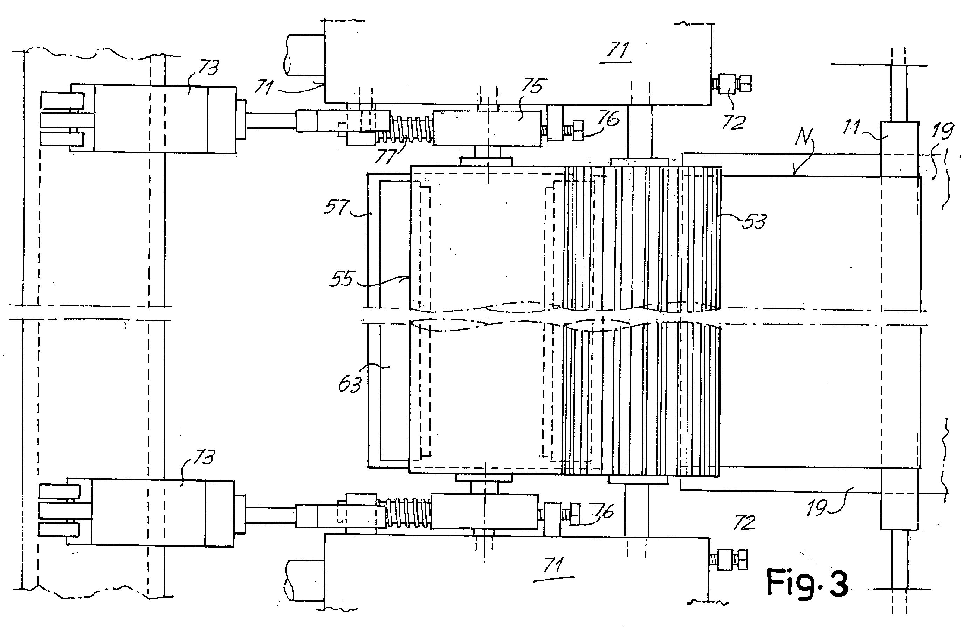

Figure 3 shows a plan view of the unit or system to apply oil to the substrate to be metallized.

### Detailed description of a preferred embodiment of the invention

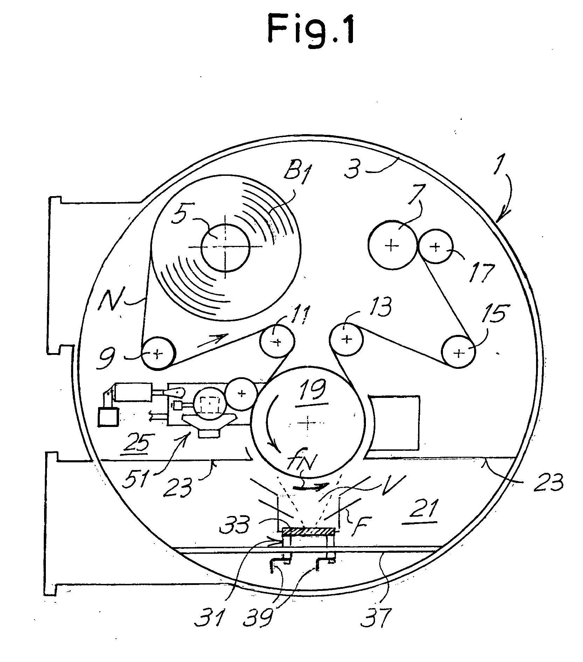

Figure 1 schematically shows, in a section along a vertical plane, the inside of a vacuum metallization system.

It comprises a container or main evacuable chamber 3, housing two supports 5 and 7 for the reels of the web substrate N to be metallized, for example a polymer film, a strip of paper or the like. Arranged on the support 5 is a reel B1 of substrate still to be treated which is fed along a feed path defined by drive rollers 9, 11, 13 15, 17. Positioned on the support 7 is a second reel being formed, on which the substrate is wound after metallization.

Positioned between roller 11 and roller 13 is a process roller 19 with a larger diameter which projects partly inside a chamber 21 separated, by a wall 23, from the chamber above 25 in which the supports 5 and 7 for the reels of substrate are arranged. The chamber 21 is kept under a higher degree of vacuum than the chamber 25. Systems also exist in which there is no separating wall 23 and no division into chambers 21 and 25. In this case the reel being unwound, the rewinding reel, the path of the substrate N, the process roller 19 and the vaporization sources are all in the same chamber. Systems also exist in which a third chamber, known as a guard chamber, is provided adjacent to the process roller.

The web substrate N unwound from the reel B1 and fed around the process roller 19 is gradually rewound to form a reel of metallized substrate on the support 7. During unwinding, while the web substrate N is being fed around the process roller 19, a metal which has been vaporized by a series of sources 31 located in the chamber 21, under the process roller 19, is deposited on the surface thereof which is not in contact with the process roller 19. The vaporized material, schematically indicated with V, is emitted from the sources 31, which are adjacent to each other according to an alignment orthogonal to the direction FN of feed of the substrate, i.e. orthogonal to the plane of the figure. Therefore, only one source is visible in Figure 1.

The structure of the metallization system can vary and the embodiment represented in Figure 1 is only a schematic example of a possible system in which the invention can be implemented.

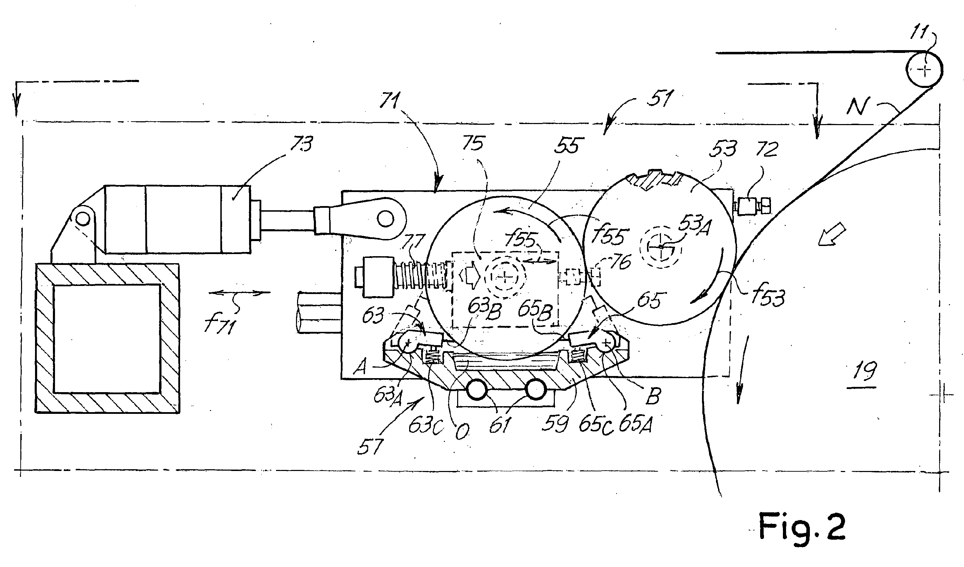

An applicator unit 51 is positioned on the process roller 19, on the feed side of the substrate N fed from the reel B1 and on which vacuum deposition must be performed, to apply, according to a suitable pattern, a thin film of oil on the surface of the substrate N before it passes in front of the metallization sources 31. The configuration of the applicator unit 51 is described in greater detail hereunder with specific reference to the diagram in Figure 2.

The unit 51 comprises a first printing cylinder 53, which has on its surface a raised pattern composed of projections with a conformation and distribution corresponding to the pattern to be produced on the substrate N by metal-free areas. The printing cylinder 53 rotates according to the arrow f53 to have a zero relative velocity with respect to the substrate N fed around the process roller 19. The cylindrical surface of the printing cylinder 53 can be produced at least in part in an elastically yielding material.

The printing cylinder 53 is tangent to an anilox cylinder 55 rotating according to arrow f55, preferably at a peripheral speed equal to the speed of the printing cylinder 53. This cylinder 55 forms a distributor cylinder of the oil on the raised pattern of the printing cylinder 53. The surface of the anilox cylinder 55 is engraved, for example with laser engraving, to create thereon a plurality of small cells (screen), inside which an oil distributed by a distributor unit 57 described in detail hereunder and forming the oil source, is retained. The oil that is retained in the cells of the anilox cylinder 55 is then transferred to the front surfaces of the projections or protuberances of the printing cylinder 53.

The distribution unit 57 in substance has a reservoir or container 59 containing oil O optionally heated by a system of resistors 61. Two doctor blades, indicated generically with 63 and 65, close the space between the aperture of the reservoir 59 and the cylindrical surface of the anilox cylinder 55. Each of the two doctor blades 63, 65 comprises, in the example shown, a substantially rigid profile 63A, 65A oscillating about an axis of oscillation A or B and extending substantially for the entire longitudinal extension of the anilox cylinder 55 and of the reservoir or container 59. Each of these profiles 63A, 63B is provided with a flexible sheet 63B, 65B which, during operation of the device, is in contact with the cylindrical side surface of the anilox cylinder 55.

The profiles 63A, 65A are stressed by compression springs 63C, 65C so as to press the sheets 63B, 65B against the cylindrical surface of the cylinder 55. The compression springs 63C, 65C can be adjustable to adjust the pressure of the doctor blades on the anilox cylinder.

The members described hereinbefore, namely the distribution unit or source 57, the anilox or distributor cylinder 55 and the printing cylinder 53, are supported by side panels 71. These side panels can be adjusted to be closer to or farther from the cylindrical surface of the process roller 19 and consequently the substrate N fed around said roller, or can be thrust with a controlled force against said roller. Advantageously, adjustment of thrust and/or of the position can take place separately for the two side panels, i.e. for the two ends of the printing cylinder 53 and of the anilox or distributor cylinder 55.

The movement to adjust or to move the side panels 71 towards or away from the process roller 19 is indicated with f71. The printing cylinder 53 is supported on the side panels on an axis 53A fixed with respect to said side panels 71, so that a movement according to f71 to adjust or move the side panels 71 towards the process roller means that the printing cylinder 53 is moved closer to the process roller 19 to a greater or lesser extent. Alternatively, the reciprocal position between the process roller 19 and the printing cylinder 53 can remain the same and equal to the thickness of the web material or substrate N to be treated, but the thrust exerted by the cylinder 53 on the process roller 19, and consequently the contact force with the substrate N, can be suitably adjusted or controlled.

According to an advantageous embodiment, a respective actuator 73 is associated with each of the two side panels 71, in this example represented by a hydraulic or pneumatic piston-cylinder actuator. Alternatively, a mechanical or electrical actuator can be used, such as an electronically controlled electric motor with a mechanical transmission such as a worm screw. Further, in another embodiment a simple elastic thrust member can be provided.

The arrangement of two actuators associated with the respective two side panels allows separate adjustment of the force with which each of the two side panels 71 is thrust towards the process roller 19. This makes it possible to obtain uniform contact pressure between the printing cylinder 53 and the web material or substrate N across the entire width of the latter. Alternatively, or in combination, the actuators 73 can be produced to control the position of the printing cylinder with respect to the process roller, adjusting the two ends of said cylinder separately.

A possible and advantageous solution can comprise an electric actuator with electronic control of the position and optionally control of the thrust for each side panel.

In an advantageous embodiment of the invention, an adjustable stop 72 is associated with each side panel 71, so that the position of each side panel can be adjusted separately from the other to allow optimal positioning of the printing cylinder with respect to the process roller 19, the operating position being maintained through the thrust of the actuators 73 against the adjustable stops 72.

When the two adjustable stops 72 are provided, the actuators 73 can operate by taking the respective side panels in stable contact against these stops, which will define the reciprocal adjustable position of the printing cylinder with respect to the process roller 19. Alternatively, or in combination, the stops can be elastic. In this case the actuators can thrust the side panels 71 against the stops 72, which give sufficient elasticity to allow the system to adapt to any variations in the operating conditions, without undesirable stresses arising.

In practice, various solutions can be used which comprise, individually or in combination:
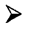 position-controlled actuators, for example with position encoders,
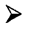 thrust-controlled actuators, for example with load cells or other thrust sensors,
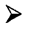 rigid adjustable stops, in which case the actuators preferably have an elasticity of their own, they are for example pneumatic actuators,
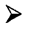 elastic or at least moderately elastic adjustable stops.

It would also be possible to use only the actuators 73 with thrust and/or position control systems, without the stops, for example through suitable selection of the type of actuator and of the optional adjustment ring.

The anilox cylinder 55 is supported in turn at the ends thereof by supporting blocks 75 mounted on guides (not shown) integral with the side panels 71. A thrust member 77 on each of the two side panels 71 separately pushes the corresponding end of the anilox cylinder 55 towards the printing cylinder 53, obtaining in this case as well a substantially uniform distribution of pressure (along the axial extension of the cylinders 55, 53) between said cylinders. Alternatively, according to a preferred embodiment, an adjustable stop 76 for the respective supporting block 75 is arranged on each side panel 71, so that the position of the anilox cylinder 55 with respect to the printing cylinder 53 can be adjusted optimally.

The thrust member 77 can be - as indicated by way of example and preferably - an elastic member, but can also be an actuator, for example of the hydraulic, pneumatic, electric or mechanical type.

Also in the case of the thrust members 77 and the adjustable stops 76 (just as in the case of the actuators 73 and the stops 72) it would be possible to use actuators of various types or simple elastic thrust members, in combination with adjustable rigid or elastic stops, to adjust the position and/or thrust of the anilox cylinder 55 with respect to the printing cylinder 53, with separate adjustment at the two ends of the cylinder 55.

The distributor 57 is preferably integral with the supporting blocks 75 so as to move with them together with the anilox distributor cylinder 55. Alternatively to the representation in the drawing, in which the anilox cylinder 55 is immersed in the oil O contained in the reservoir 59, the anilox cylinder 55 could be positioned above the free surface of the oil O and the latter could be made to evaporate from the reservoir and condense on the surface of the anilox cylinder 55.

With the expedients described above optimal adjustment and extremely regular operation of the applicator device 51 are obtained, allowing metal-free areas with high definition, precision and repeatability of the pattern to be produced.

In at least some of the possible configurations of the applicator unit, the force with which one or other of the cylinders is thrust and/or the reciprocal position can be adjusted with the metallization chamber closed using an external control and also, if necessary, during the deposition process. In this way further advantages are obtained with regard to function and quality of the final product.

It is understood that the drawing only shows an exemplification provided purely as a practical arrangement of the invention, which can vary in forms and arrangement without however departing from the scope of the concept on which said invention is based.

## Claims

1. A system for vacuum deposition of a coating on a web material (N), comprising: an evacuable chamber; in said chamber a feed path of the web material in a vacuum environment; along said feed path, a process roller (19) around which said web material is guided; associated with said process roller, at least one vaporization source (31) of at least a first material to form said coating; upstream of said at least one source, along the feed path of the web material, an applicator unit (51) to apply a masking agent on the web material according to a pre-established pattern, said applicator unit comprising a printing cylinder (53), cooperating with a distributor cylinder (55) of said masking agent, and a source (57) of said masking agent; **characterized in that** said applicator unit (51) comprises at the side adjustment means (73) separate for each of the two sides, to adjust the position of the applicator unit (51) with respect to the process roller (19) and/or the relative contact force between the applicator unit and the process roller.

2. Device as claimed in claim 1, **characterized in that** said at least one vaporization source is a metal vaporization source.

3. Device as claimed in claim 1 or 2, **characterized in that** said adjustment means (73) comprise, for each side of the applicator unit (51), a thrust member (73) which stresses the printing cylinder (53) towards the process roller (19).

4. Device as claimed in claim 3, **characterized in that** said thrust member is selected from the group comprising: elastic means, pneumatic actuators, mechanical actuators, hydraulic actuators, electric actuators.

5. Device as claimed in claim 3 or 4, **characterized in that** position adjusting means, preferably separate for each side of the applicator member, are associated with said thrust members.

6. Device as claimed in claim 3, 4 or 5, **characterized in that** thrust adjusting means, preferably separate for each side of the applicator member, are associated with said thrust members.

7. Device as claimed in one or more of claims 3 to 6, **characterized in that** said thrust members are elastic.

8. Device as claimed in one or more of claims 3 to 7, **characterized in that** a respective adjustable stop (72) defining the position of the printing cylinder with respect to the process roller, is associated with each end of the applicator unit (51).

9. Device as claimed in claim 8, **characterized in that** said adjustable stop is elastic.

10. Device as claimed in one or more of the previous claims, **characterized in that** said printing cylinder, said distributor cylinder (55) and said source (57) are carried at the ends thereof by a pair of side panels (71).

11. Device as claimed in claims 8 and 10 or 9 and 10, **characterized in that** said stops (74) cooperate with said side panels (71).

12. Device as claimed in claim 8, 9 or 10, **characterized in that** one of said thrust members (73) is associated with each of said side panels (71).

13. Device as claimed in claim 10, 11 or 12, **characterized in that** said distributor cylinder (55) is supported by said side panels (71) with the interposition of supporting blocks (75), movable with respect to said side panels.

14. Device as claimed in claim 13, **characterized in that** a thrust member is associated with each of said supporting blocks, to stress, separately at both of the ends thereof, said distributor cylinder (55) towards said printing cylinder (53).

15. Device as claimed in claim 14, **characterized in that** said thrust members comprise means selected from the group comprising: elastic thrust members, mechanical actuators, pneumatic actuators, hydraulic actuators, electric actuators.

16. Device as claimed in claim 14 or 15, **characterized in that** said thrust members associated with said supporting blocks are associated with means to adjust the position of said blocks, the thrust stress of the distributor cylinder on the printing cylinder, or both.

17. Device as claimed in one or more of claims 14 to 16, **characterized in that** said thrust members are elastic.

18. Device as claimed in one or more of claims 13 to 16, **characterized in that** a respective adjustable stop (76) is associated with each of said side panels (71), to define the relative position of the distributor cylinder with respect to the printing cylinder.

19. Device as claimed in claim 18, **characterized in that** said stops (76) are elastic.

20. Device as claimed in one or more of the previous claims, **characterized in that** said source (57) comprises a tank or container (59) with an opening inside which said distributor cylinder extends.

21. Device as claimed in claim 20, **characterized in that** two doctor blades (63, 65), cooperating with the cylindrical surface of the distributor cylinder (55), are associated with said opening.

22. Device as claimed in claim 21, **characterized in that** each of said doctor blades (63, 65) is stressed elastically against the cylindrical surface of said distributor cylinder (55).

23. Device as claimed in claim 21 or 22, **characterized in that** each of said doctor blades comprises a substantially rigid profile (63A, 65A), oscillating about an axis parallel to the axis of the distributor cylinder (55) and integral with a flexible sheet (63B, 65B), extending parallel to the axis of oscillation of the respective doctor blade, said flexible sheet being in contact with the cylindrical surface of the distributor cylinder (55) during use.

24. Device as claimed in claim 23, **characterized in that** each of said doctor blades is stressed elastically against the cylindrical surface of the distributor cylinder (55), preferably with adjustable stress.

25. Device as claimed in one or more of the previous claims, **characterized in that** said source has means to heat the masking agent.

26. Device as claimed in one or more of the previous claims, **characterized in that** said masking agent is an oil.

27. Device as claimed in one or more of the previous claims, **characterized in that** said printing cylinder is supported removably for rapid replacement.

28. Device as claimed in claim 27, **characterized in that** said printing cylinder is supported by end supports, at least one of which can be opened for rapid replacement of the printing cylinder.

29. Device as claimed in one or more of the previous claims, **characterized in that** said source of masking agent comprises a reservoir and **in that** said distributor cylinder is partly immersed in the liquid masking agent contained in said reservoir.

30. Device as claimed in one or more of claims 1 to 28, **characterized in that** said source of masking agent comprises a reservoir and means for evaporation of said masking agent from said reservoir, the distributor cylinder being arranged to obtain on the cylindrical surface thereof the condensation of the masking agent evaporated from said source.

31. Device as claimed in one or more of the previous claims, **characterized in that** said adjustment means can be operated from the outside of said chamber, if necessary during the deposition process.
